(19) Europäisches Patentamt
European Patent Office
Office européen des brevets

(11) **EP 2 680 029 A1**

(12) **EUROPÄISCHE PATENTANMELDUNG**

(43) Veröffentlichungstag:
**01.01.2014 Patentblatt 2014/01**

(51) Int Cl.:
***G01S 7/486*** *(2006.01)*     ***H03M 1/12*** *(2006.01)*

(21) Anmeldenummer: **12173911.4**

(22) Anmeldetag: **27.06.2012**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(71) Anmelder: **Leica Geosystems AG**
**9435 Heerbrugg (CH)**

(72) Erfinder: **Stutz, Reto**
**CH-9442 Berneck (CH)**

(74) Vertreter: **Harmann, Bernd-Günther**
**Kaminski Harmann**
**Patentanwälte AG**
**Landstrasse 124**
**9490 Vaduz (LI)**

(54) **Distanzmessverfahren und Distanzmesser**

(57) In einem Distanzmessverfahren mit wenigstens einem Aussenden wenigstens eines Messsignals auf ein Zielobjekt wird wenigstens ein Startsignal (S) erzeugt und das vom Zielobjekt zurückgestreute Messsignals als Zielsignal (Z) empfangen. Das Zielsignal (Z) und ggf. auch das Startsignal (S) wird in einem ersten und einem zweiten Abtasten mit unterschiedlichen Abtastraten abgetastet und die Distanz zum Zielobjekt aus der relativen Lage von Startsignal (S) und Zielsignal (Z) bestimmt.

Fig. 5

EP 2 680 029 A1

**Beschreibung**

Die Erfindung betrifft ein Distanzmessverfahren nach dem Oberbegriff des Anspruchs 1 sowie einen Distanzmesser nach dem Oberbegriff des Anspruchs 13.

Im Bereich der elektronischen bzw. elektrooptischen Distanzmessung sind verschiedene Prinzipien und Verfahren bekannt. Ein Ansatz besteht darin, gepulste elektromagnetische Strahlung, wie z.B. Laserlicht, auf ein zu vermessendes Ziel auszusenden und nachfolgend ein Echo von diesem Ziel als rückstreuendes Objekt zu empfangen, wobei die Distanz zum zu vermessenden Ziel anhand der Laufzeit des Pulses bestimmt wird. Solche Pulslaufzeitmesser haben sich mittlerweile in vielen Bereichen als Standardlösungen durchgesetzt.

Zur Detektion des zurückgestreuten Pulses werden unterschiedliche Ansätze verwendet.

Bei der sogenannten Schwellwertmethode wird ein Lichtpuls detektiert, wenn die Intensität der einfallenden Strahlung einen gewissen Schwellwert überschreitet.

Der andere Ansatz basiert auf der Abtastung bzw. dem Sampling des rückgestreuten Pulses. Ein emittiertes Signal wird detektiert, indem die von einem Detektor erfasste Strahlung abgetastet, innerhalb des abgetasteten Bereichs ein Signal identifiziert und schliesslich dessen Lage bestimmt wird. Durch die Verwendung einer Vielzahl von Abtastwerten kann ein Nutzsignal auch unter ungünstigen Umständen identifiziert werden, so dass auch grössere Distanzen oder verrauschte bzw. mit Störungen behaftete Hintergrundszenarien bewältigt werden können. Im Stand der Technik erfolgt ein Sampling durch Abtastung vieler identischer Pulse mit Verschiebung des Zeitfensters bzw. der Phase, wobei derzeit sehr schnelle Schaltungen realisiert werden können, die hochfrequent genug sind, um einzelne Pulse abzutasten.

Problematisch sind jedoch die Anforderungen an die Signalabtastung und die Voraussetzungen für eine Signalrekonstruktion, insbesondere bei der Verwendung von veränderlichen oder verzerrten Signalen. Aufgrund der technisch nach oben begrenzten Abtastraten können nicht alle Signalanteile in gleicher Weise abgetastet werden. Wird das sog. Nyquist-Abtasttheorem nicht beachtet, so können sogenannte Aliasing-Effekte auftreten, welche die Signalrekonstruktion verfälschen und somit die Messgenauigkeit verringern. Im Stand der Technik sind hierbei Lösungen bekannt, welche dennoch eine geringfügige Verletzung der Nyquist-Bedingung hinnehmen oder aber die höherfrequenten Signalanteile durch Filterung soweit reduzieren, dass die Nyquist-Bedingung für das gefilterte Signal erfüllbar ist.

So wird in der WO 2011/076907 eine Vorrichtung zur hochgenauen Distanzmessung nach dem Prinzip der direkten Abtastung des reflektierten Signals geoffenbart, bei der das Empfangssignal mit einer Samplingschaltung abgetastet und anschliessend quantisiert wird. Dem Empfangssignalpfad ist vor der Abtastung ein Filter hoher Ordnung zugeteilt. Dieses Filter hat typischerweise die Ordnung 6 oder höher und ist nicht wie bei den anderen Vorrichtungen nach dem Stand der Technik als ein einfaches Antialiasing-Filter 1., 2. oder höchstens 3. Ordnung ausgelegt. Bei einem solchen Distanzmessverfahren ist eine vollständige Identifikation der Kurvenform nicht mehr zwingend erforderlich. Da vor dem Abtasten die Signalbandbreite so reduziert wird, dass alle für die distanzrelevanten Frequenzen unterhalb der halben Samplingfrequenz liegen, kann nach dem Nyquist-Theorem das dann verbleibende und für den beabsichtigten Messzweck ausreichende distanzrelevante Signal per Algorithmik vollständig rekonstruiert werden und somit auch dessen genaue Lage bestimmt werden. Die Messung funktioniert auch noch bei sich verändernden Signalen und die Genauigkeit kann durch diesen Ansatz gesteigert werden. Die Voraussetzung führt eine Rekonstruktion ist allerdings, dass der dominante Anteil des Signals innerhalb eines Nyquist-Bandes liegen muss, wobei vorzugsweise das erste Frequenzband verwendet wird.

Andere Verfahren bzw. Vorrichtungen des Stands der Technik halten zwar in erster Näherung die Nyquist- oder Shannon-Bedingung ein. Dabei wird die Bandbreite BW oder der 3dB-Abfallpunkt f3dB des Signalspektrums auf Frequenzen unterhalb der Nyquist-Grenzfrequenz fg limitiert. Da aber aufgrund der niedrigen Filterordnung der Abfall des Spektrums bei Frequenzen oberhalb der BW beziehungsweise f3dB durchwegs zu schwach ausgeprägt ist, ist das Shannon-Theorem nicht zu 100% erfüllt und die Unterdrückung von Aliasing-Effekten für eine präzise, offsetfreie Distanzmessung ist nicht gegeben.

Die Lösungen des Stands der Technik verwenden somit ausgeklügelte Filter-Konzepte, die eine Einhaltung des Abtast-Theorems gewährleisten oder aber sie sind nicht in der Lage, Aliasing-Effekte im für hochpräzise Messungen erforderlichen Masse zu vermeiden.

Die Aufgabe der vorliegenden Erfindung besteht daher in der Bereitstellung eines neuen Distanzmessverfahrens bzw. eines neuen Distanzmessers, welcher diese Nachteile vermeidet oder verringert.

Es ist eine weitere Aufgabe, einen hochgenauen Distanzmesser bzw. ein Distanzmessverfahren ohne Notwendigkeit einer Filterung oder aber einem verringerten Filterungsaufwand vor dem Abtastvorgang bereitzustellen.

Eine weitere Aufgabe besteht darin, einen Distanzmesser bereitzustellen, der auch bei nichtlinear verzerrten Impulsen, wie z.B. bei Signalsättigung, genaue Messungen ermöglicht.

Eine weitere Aufgabe ist es, einen Distanzmesser bereitzustellen, der auch die Nutzung höherfrequenter Signalanteile ermöglicht, insbesondere ohne Beschränkung durch das Shannon-Theorem.

Eine weitere Aufgabe ist es, einen hochgenauen Distanzmesser bereitzustellen, der auch mit einfachem Aufbau, insbesondere mit langsamen Analog-Digital-Wandlern, hochgenaue Messung erlaubt.

Insbesondere besteht die Aufgabe, einen Distanzmesser nach dem Laufzeitmessverfahren mit Signalabtastung so weiterzuentwickeln, dass eine absolute Genauigkeit im mm-Bereich oder im sub-mm-Bereich gewährleistet ist. Dabei soll im Idealfall die Präzisionsklasse der Distanzmesser nach dem Phasenmessprinzip erreicht werden.

Diese Aufgaben werden erfindungsgemäss durch die Merkmale der Ansprüche 1 oder 13 bzw. durch die Merkmale der abhängigen Ansprüche gelöst bzw. die Lösungen fortgebildet.

Die Erfindung betrifft Distanzmesser, welche ein Messsignal auf ein in seiner Distanz zu vermessendes Zielobjekt aussenden und nach einer Wechselwirkung mit dem Zielobjekt den zurückgeworfenen Signalanteil als Zielsignal wieder empfangen und auswerten. Typischerweise wird hierzu Licht im sichtbaren oder unsichtbaren Spektralbereich verwendet, das beispielsweise von einer Laserdiode, einem Festkörperlaser, wie z.B. einem Q-switched bzw. gütegeschalteten Mikrochiplaser, oder einer LED erzeugt wird. Grundsätzlich kann der erfindungsgemässe Ansatz jedoch auch für andere Messsignaltypen Verwendung finden, wie z.B. Ultraschallmesser. Die Distanz wird bei gattungsgemässen Laserdistanzmessern meist nach dem Laufzeitmessprinzip, d.h. aus der zeitlichen Differenz zwischen dem Empfangen des Startsignals und des Zielsignals bestimmt, wobei zumindest das Zielsignal zur Digitalisierung abgetastet wird.

Die erfindungsgemässe Lösung basiert auf einem solchen Ansatz einer Abtastung des Zielsignals durch einen Analog-Digital-Wandler, verwendet hierzu jedoch im Gegensatz zum stand der Technik verschiedene Abtastraten bzw. Frequenzen. Durch diese wenigstens zwei Abtastvorgänge des Zielsignals mit unterschiedlichen Abtastraten verschieben sich die relativen Lagen der Abtastpunkte bzw. Samplingpunkte gegenüber dem Signal. Ein Durchstimmen der Abtastraten erlaubt somit ein Durchfahren des Signalverlaufs mit den Abtastpunkten, so dass bei den verschiedenen Abtastvorgängen der Signalverlauf an jeweils unterschiedlichen Stellen abgetastet wird. Aus der Gesamtheit dieser Abtastvorgänge und ihrem Verhalten beim Durchstimmen der Abtastraten können Informationen über den Signalverlauf gewonnen werden. Insbesondere kann hierdurch eine optimierte Abtastrate bestimmt werden, welche für die jeweilige Distanz bzw. einen zugeordneten Distanzbereich hochgenaue Messungen erlaubt. Die Abtastrate des Analog-Digital-Wandlers wird somit an einen Distanzbereich angepasst, wobei ansonsten durch Aliasing entstehende Effekte wegfallen oder aber algorithmisch berücksichtigt werden können.

Das wiederholte, mindestens aber zweifach durchgeführte Abtasten mit unterschiedlichen Abtastraten sondiert dabei das vorab ausgesandte und von einem Ziel wieder zurückgeworfene Zielsignal sowie wenigstens eine Kopie bzw. ein erneut erzeugtes Signal mit gleichem Signalverlauf. Die beiden abzutastenden Signale können beispielsweise erzeugt werden, indem bei unveränderter Distanz oder mit bekannten Distanzunterschieden eine Mehrzahl von Signalen ausgesandt, empfangen und mit unterschiedlichen Raten abgetastet werden, so dass ein sequentielles Abtasten von Zielsignalen aus unterschiedlichen Messvorgängen zum gleichen Ziel erfolgt. Dies entspricht somit einem erneuten Durchführen des externen Teils des Messvorgangs. Alternativ oder ergänzend kann auch der Empfänger, z.B. mittels Strahlteiler, mehrkanalig ausgelegt werden, wobei jeder der Kanäle mit unterschiedlicher Rate abgetastet wird. Dies entspricht einer Parallelisierung des internen Teils des Messvorgangs, wobei für jeden Kanal eine Kopie des Signals zur Verfügung gestellt wird. Wird diese Mehrkanaligkeit mit dem mehrfachen Aussenden von Signalen kombiniert, d.h. beide Ansätze für ein zweites Abtasten gleichzeitig realisiert, so kann ein Signal stets parallel in zwei Kanälen mit jeweils eigenem Analog-Digital-Wandler mit unterschiedlichen Raten abgetastet werden, wobei für jedes ausgesendete Signal jeweils die Abtastraten der Kanäle verändert werden.

Nach dem Abtastvorgang erfolgt die Bestimmung der Distanz mittels Laufzeitverfahren, d.h. anhand einer Zeitmessung zwischen den Signalen, der eine Distanz zugeordnet wird. Typischerweise können hierbei einzelne Pulse ausgesendet werden, erfindungsgemäss ist es jedoch auch möglich komplexere Signalstrukturen bzw. Signalmuster zu verwenden.

Das Verschieben der Abtastrate bzw. Samplingfrequenz kann mit verschiedenen Ansätzen genutzt werden.

Ein erster Ansatz nutzt ein zum Zielsignal korrespondierendes Startsignal, das vor bzw. beim Aussenden des Messsignals erzeugt wird, z.B. durch Verwenden eines internen Referenzpfads, über den ein Teil des Messsignals geräteintern auf den Empfänger geführt wird. Dieses Startsignal wird ebenfalls in zum Zielsignal gleicher Weise vom Empfänger bzw. dem Analog-Digital-Wandler abgetastet. Durch die Veränderung der Abtastrate kann das der jeweiligen Rate zugeordnete Abtastraster so verschoben werden, dass Start- und Zielsignal in gleicher Weise, d.h. an identischen Punkten des Signalverlaufs abgetastet werden. Eine vollständige Rekonstruktion des Pulses ist somit nicht mehr notwendig, solange die Abtastrate so gewählt wird, dass der Abstand zwischen Start- und Zielsignal einem ganzzahligen Vielfachen des Abtastintervalls, d.h. des Abstands zwischen den Abtastpunkten, entspricht. Beide Signale werden dann an den gleichen Stellen und somit in direkt vergleichbarer Weise abgetastet. Somit wird die Samplingfrequenz des Analog-Digital-Wandlers so angepasst, dass beide Signale gleich, d.h. mit gleicher relativer Lage zu den Abtastpunkten, im Samplingraster liegen. Durch Aliasing auftretende Fehler werden beim Abtasten beider Signale, d.h. sowohl von Zielsignal als auch vom Startsignal, dupliziert und können somit bei einem Vergleich beider Signale, ggf. nach einer Amplitudenanpassung, subtrahiert bzw. eliminiert werden.

Dieser Ansatz kann auch mit nur zwei Abtastraten durchgeführt werden, wenn bspw. der erste Abtastvorgang als Vormessung zur Bestimmung einer Grobdistanz genutzt wird. Anhand der Grobdistanz kann dann, z.B. aus einer Tabelle, die für diese Entfernung optimale Abtastrate gewählt werden.

Ein anderer Ansatz betrachtet das Zielsignal in isolierter Weise, wobei die Aliasing-Effekte bestimmt werden. Hierzu wird das Abtastraster durch Verändern der Abtastrate über den Signalverlauf verschoben, so dass der Signalverlauf zumindest teilweise abgefahren bzw. abgescannt wird. Aus den Messungen, d.h. der Veränderung des ermittelten Signalverlaufs oder der ermittelten Distanz gegenüber der Veränderung der Abtastrate, kann der Effekt des Aliasing bestimmt und dieses eliminiert werden. Bei diesem Ansatz ist es vorteilhaft, wenn für die verschiedenen Abtastraten eine Phasenstarrheit oder zumindest eine definierte Phasenlage gegeben ist, so dass bei alleiniger Abtastung nur des Zielpulses keine unbestimmten Phasenverschiebungen zwischen den Abtastvorgängen auftreten. Alternativ oder ergänzend kann als Startsignal bspw. auch ein elektronisch generiertes Startsignal genutzt werden, das keine Kopie des Zielsignals sein muss.

Im Prinzip wird durch die unterschiedliche Abtastrate ein Subsampling oder gegenüber einer einfachen Abtastung eine feinere Abtastung des Signals erreicht.

Wird nur das Zielsignal verwendet, was bspw. bei einem elektronisch erzeugten Startsignal möglich ist, so besteht die Optimierung der Signalposition darin, dieses in eine für die Auswertung optimale Position zum Abtastraster zu setzen. Beispielsweise kann das Zielsignal so in das Abtastraster gelegt werden, dass die erste Ableitung des Zielsignals an einem Abtastpunkt oder einem Menge von zeitlichen Intervallen zugeordneten Abtastpunkten möglichst gross ist, was einer Maximierung der Signaländerung pro Distanzänderung entspricht.

Grundsätzlich kann der erfindungsgemässe Ansatz auch mit Verfahren des Stands der Technik kombiniert werden. So können insbesondere auch Filterverfahren, wie sie bspw. in der WO 2011/076907 beschrieben werden, zum Einsatz kommen.

Das erfindungsgemässe Distanzmessverfahren sowie der erfindungsgemäss Distanzmesser werden nachfolgend anhand von in der Zeichnung schematisch dargestellten Ausführungsbeispielen rein beispielhaft näher beschrieben. Im einzelnen zeigen

Fig.1          ein Blockschaltbild eines Ausführungsbeispiels des erfindungsgemässen Distanzmessers;

Fig.2-3        die Prinzipdarstellung eines Distanzmessers nach dem Laufzeitmessprinzip nach dem Stand der Technik;

Fig.4-5        die Prinzipdarstellung des erfindungsgemässen Distanzmessverfahrens;

Fig.6a-b       die unterschiedlichen Spektren für Filter 1. und 2. Ordnung;

Fig.7a-b       die unterschiedlichen Spektren für Filter 1. und 2. Ordnung als Funktion der Abtastrate;

Fig.8a-c       die Unterschiede zwischen analogem Zeitsignal und aus diesem interpolierten digitalem Signal für ein Filter 1. Ordnung und verschiedene Relativpositionen zwischen Signal und Abtastraster;

Fig.9a-c       die Unterschiede zwischen analogem Zeitsignal und aus diesem interpolierten digitalem Signal für ein Filter 2. Ordnung und verschiedene Relativpositionen zwischen Signal und Abtastraster;

Fig.10a-b      das Auftreten von Distanzfehlern bei der Abtastung eines Signals mit Filtern verschiedener Ordnung und Relativpositionen zwischen Signal und Abtastraster;

Fig.11a-b      die Erläuterung der Gesamtfehler für Distanzmessverfahren des Stands der Technik gegenüber dem erfindungsgemässen Distanzmessverfahren;

Fig.12         die Prinzipdarstellung einer erfindungsgemässen linearen Interpolation des Stopp-Signals und

Fig.13         die Prinzipdarstellung einer erfindungsgemässen Erstellung einer Look-Up-Tabelle.

Fig.1 zeigt ein Blockschaltbild eines Ausführungsbeispiels des erfindungsgemässen Distanzmessers. Der Distanzmesser weist eine Messsignalquelle 1 zum Aussenden wenigstens eines Messsignals MS, insbesondere eines Lichtsignals, auf ein Zielobjekt 2 auf, wobei wenigstens ein Startsignal erzeugt wird. Als Messsignalquelle 1 kommen insbesondere Laserdioden, Festkörperlaser oder LEDs in Frage. Das Startsignal kann als elektronisch generiertes Signal bereitgestellt werden oder aber, wie in diesem Ausführungsbeispiel, durch Teilen oder Umschalten des Messsignals MS erzeugt werden. Hierzu wird das Messsignal MS bspw. über einen Strahlteiler 4 geführt und nachfolgend auf das Zielobjekt 2 emittiert. Der andere Teil des Messsignals MS wird über einen geräteinternen Referenzpfad zu einem weiteren Strahlteiler 5 geführt und dort wieder in den Empfangstrahlengang eingekoppelt. Durch diese Anordnungen werden somit eine geräteexterne Messstrecke und eine geräteinterne Referenzstrecke definiert, wobei das Startsignal durch Auskoppeln und die geräteinterne Strahlführung bereitgestellt wird. Neben der Auskopplung mittels Strahlteiler 4 kann auch ein aufeinanderfolgendes Durchlaufen von geräteexterner Messstrecke und geräteinterner Referenzstrecke realisiert werden, z.B. durch ein Umschaltelement, das jeweils nur eine der Strecken freigibt und hin- und hergeschaltet wird.

Das vom Zielobjekt 2 zurückgeworfene Messsignal MS wird auf einen Empfänger 3 zum Detektieren geführt, wo es als Zielsignal detektiert und nach einer Verstärkerstufe 6 von einer nachfolgenden Abtastschaltung mit einem Analog-Digital-Wandler 8 zur Bestimmung der relativen Lage von Start- und Zielsignal abgetastet wird. Vor dem Abtasten durch den Analog-Digital-Wandler 8 kann eine Filterung durch einen Tiefpass-Filter 7 erfolgen. Die Distanz zum Zielobjekt wird in einer Steuer- und Auswertekomponente 9 aus der relativen Lage von Start- und Zielsignal bestimmt.

Die Abtastschaltung ist hierzu so ausgebildet, dass das Zielsignal mit wenigstens zwei unterschiedlichen Abtastraten abgetastet wird. Dabei wird der Analog-Digital-Wandler 8 durch die Steuer- und Auswertekomponente 9 über einen Frequenzgenerator 10, insbesondere einen Synthesizer, vorzugsweise einen Direct Digital Synthesizer oder Fractional N Synthesizer, mit Reference-Clock 11 zur Frequenzsynthese gesteuert. Die Steuer- und Auswertekomponente 9 steuert zudem über eine Verstärkerstufe 12 die Messsignalquelle 1, wobei über einen weiteren, hier nicht dargestellte Frequenzgenerator auch die Frequenz der Messsignalquelle 1 entsprechend verstellt werden kann, so dass sowohl die Frequenzen von Empfänger als auch Quelle entsprechend angepasst werden können.

In diesem Ausführungsbeispiel werden wenigstens zwei jeweils über geräteexterne Messstrecke und geräteinterne Referenzstrecke geführte Messsignale nacheinander mit unterschiedlichen Abtastraten abgetastet. Hierbei werden bei jedem Abtastvorgang Start- und Zielsignal gemeinsam mit einer Abtastrate in einem Vorgang analysiert.

Alternativ oder ergänzend können Empfänger und Abtastschaltung aber auch so ausgebildet und angeordnet sein, dass das vom Zielobjekt 2 zurückgestreuten Messsignal MS beim Empfang geteilt und parallel in zwei Kanälen mit jeweils einem Analog-Digital-Wandler 8 mit den unterschiedlichen Abtastraten abgetastet wird.

In beiden Alternativen wird wenigstens ein zweites Abtasten des Zielsignals bewirkt, wobei beim zweiten Abtasten eine Kopie des vom Zielobjekt zurückgestreuten Messsignals oder das Ergebnis eines erneuten Sende- und Empfangsvorgangs als Zielsignal abgetastet wird und das erste und zweite Abtasten unterschiedliche Abtastraten aufweisen.

In Fig.2-3 wird das Laufzeitmessprinzip für einen Pulslaufzeit-Distanzmesser nach dem Stand der Technik erläutert. In dem Distanzmesser sind die Messsignalquelle 1 und der Empfänger 5 angeordnet. Die Messsignalquelle 1 emittiert einen Lichtpuls, der nach der Reflektion bzw. Rückstreuung an einem Ziel, z.B. einem Retroreflektor 13, wieder als zurückgestreuter Lichtpuls vom Empfänger 5 detektiert wird. Anstelle der Lichtpulse kann auch ein Muster, z.B. aus einer Folge von Pulsen oder ein Rechtecksignal, als Messsignal verwendet werden. Beim Aussenden wird ein Teil des Messsignals zur Erzeugung des Startsignals S über die geräteinterne Referenzstrecke geführt, so dass dieses zeitlich früher als das vom Zielobjekt zurückgeworfene Zielsignal Z empfangen wird. Diese Situation wird in Fig.3 veranschaulicht, wobei die Signalimpulses s(t) gegen die Zeit t aufgetragen sind und als Signalformen Pulse gezeigt werden. Startsignal S und Zielsignal Z werden von einem Analog-Digital-Wandler mit einer Abtastrate gemeinsam abgetastet, wobei beide Signale in einem Abtastraster aus Abtastintervalle 14 liegen und durch eine Zahl N von Abtastintervallen beabstandet sind. In Verfahren des Stands der Technik werden nun Startsignal S und Zielsignal Z an den Abtaststellen erfasst, die Signale rekonstruiert und deren zeitliche Abstand bestimmt, wozu grundsätzliche verschiedene Verfahren, wie z.B. Autokorrelation, zur Verfügung stehen. Aus dem zeitlichen Abstand, d.h. der Signallaufzeit über die geräteexterne Messstrecke, wird dann in bekannter Weise die zugehörige Distanz zum Ziel bestimmt.

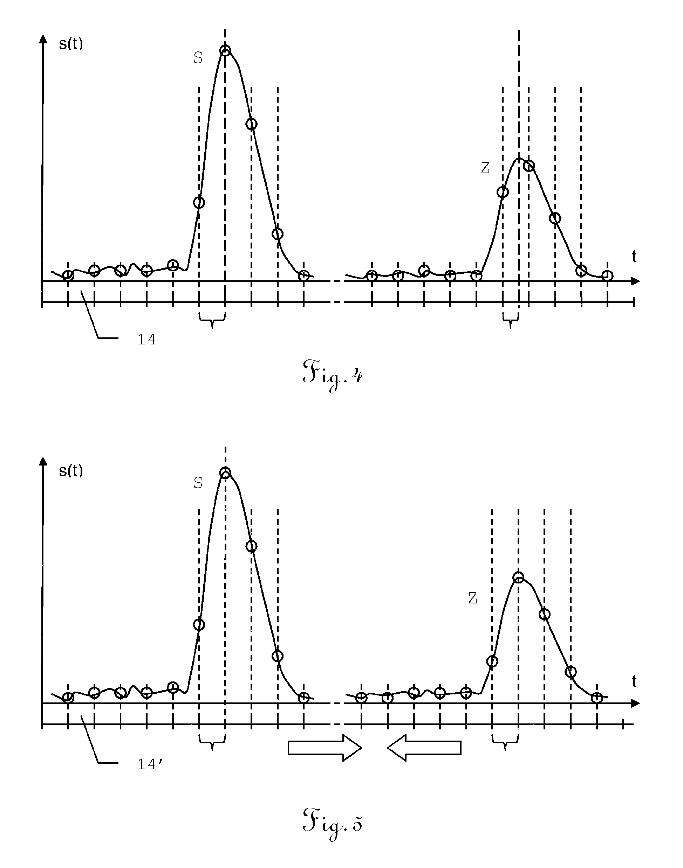

Fig.4-5 erläutern das erfindungsgemässe Distanzmessprinzip. Gezeigt werden die zu Fig.3 korrespondierenden vergrösserten Ausschnitte für das Startsignal S und das Zielsignal Z, wobei in diesem Beispiel das Zielsignal Z als abgeschwächte Kopie des Startsignals S gezeigt wird. In der Realität können jedoch für das Zielsignal Z noch Verzerrungen auftreten. In Fig.4 ist zu erkennen, dass Startsignal S und Zielsignal Z unterschiedliche relative Lagen gegenüber dem durch Abtastintervalle 14 definierten Abtastraster aufweisen, wobei die Abtastintervalle 14 die Zeiträume und damit Abstände zwischen zwei Abtastpunkten darstellen. So fällt für das Startsignal S der Scheitelpunkt mit einem Abtastpunkt zusammen, wohingegen der Scheitelpunkt für das Zielsignal Z im Abtastintervall und somit zwischen zwei Abtastpunkten zu liegt. Somit werden beide Signale an unterschiedlichen Punkten ihres Signalverlaufs abgetastet und es können bei der Subsampling-Interpolation Aliasing-Effekte auftreten, die zu Fehlern in der Distanzmessung führen.

Erfindungsgemäss wird der gleiche Signalverlauf, d.h. eine Kopie von Startsignal S und Zielsignal Z erneut oder parallel abgetastet, wobei eine andere Abtastrate verwendet wird, so dass eine Abtastung an anderen Stellen des Signalverlaufs erfolgt. Im Beispiel der gemeinsamen Abtastung von Startsignal S und Zielsignal Z verschieben sich diese Abtaststellen entlang des Signalverlaufs. Eine erfindungsgemäss gewünschte Situation tritt dann auf, wenn die in Fig.5 gezeigte Verkürzung der Abtastintervalle 14' dazu führt, dass Startsignal S und Zielsignal Z mit gleicher Phasenlage, d.h. ohne Phasenverschiebung zueinander abgetastet werden. In diesem Fall werden Flanken und Scheitelpunkte der beiden Signale in gleicher Weise abgetastet, so dass beide Signale relativ zum Abtastraster gleich positioniert sind.

Die optimale Abtastrate bzw. Samplingfrequenz kann hierbei durch Verschieben oder aber auch durch gezielte Wahl bestimmt werden. So kann die Abtastrate für das zweite Abtasten basierend auf einem Ergebnis des ersten Abtastens gewählt werden, insbesondere aufgrund einer auf dem ersten Abtasten basierenden Grobdistanz zum Zielobjekt, bestimmt wird. Eine andere Möglichkeit besteht in einem Verändern der Abtastrate, bei dem die Veränderung der damit bestimmten Distanzen analysiert und als Optimalitätskriterium verwendet wird. Auch können die für mehre Abtastraten bestimmten Distanzwerte gemittelt werden.

Insbesondere kann die Abtastrate für das zweite Abtasten basierend auf der Kenntnis einer Grobdistanz zum Zielobjekt gewählt werden, wobei diese Grobdistanz auch durch ein anderes Verfahren, wie z.B. eine Pulslaufzeitmessung nach der Schwellwertmethode, Triangulation oder auch andere geeignete Verfahren bestimmt werden. Bei Messaufgaben mit einer Abfolge von vielen Messungen und nicht zu stark strukturierten Objekten können beispielsweise auch vorangegangene Messungen zu benachbarten Punkten als Grobdistanzen verwendet werden. Die Auswahl der Abtastrate kann dabei erfolgen, indem diese einer Tabelle entnommen wird, in der Grobdistanzen geeignete Abtastraten zugeordnet werden. Solche Tabellen können insbesondere auf der Basis vorangegangener Distanzmeßvorgänge erstellt werden.

Die Abtastrate für das zweite Abtasten kann auch gemäss folgender Beziehung gewählt wird

$$f_{n+1} = f_n \cdot \lfloor N \rfloor / N$$

wobei $f_{n+1}$ die zu wählende Abtastrate für das zweite Abtasten, $f_n$ die Abtastrate für das erste Abtasten, N die Zahl der Abtastintervalle 14 zwischen dem Startsignal S und dem Zielsignal Z und $\lfloor N \rfloor$ die Abrundungsfunktion für die Zahl der Abtastintervalle 14 zwischen dem Startsignal S und dem Zielsignal Z bei $f_n$ bezeichnet.

Bei einer Startabtastrate bzw. -frequenz von $f_n$ = 500 MHz ergibt sich beispielsweise N = 789.358 als Zahl der zwischen Startsignal und Zielsignal gelegenen Abtastintervalle.

Die zugehörige Distanz D kann gemäss

$$D = \frac{N}{f_n} \cdot \frac{c}{2} = 236{,}807m$$

berechnet werden, wobei c die Lichtgeschwindigkeit bezeichnet.

Die zu wählende zweite Abtastrate ergibt sich gemäss

$$f_{n+1} = f_n \cdot \lfloor N \rfloor / N = 500MHz \cdot \frac{789}{789{,}358} = 499{,}773MHz$$

Vorrichtungsseitig wird dies realisiert, indem die Abtast- bzw. Samplingfrequenz des Analog-Digital-Wandlers mit einem Frequenzgenerator, wie z.B. einem Synthesizer (N, Fractional N, oder DDS (Direct Digital Synthesizer)) erzeugt wird. Begrenzt wird dieser Ansatz durch die Einstellgenauigkeit des Frequenzgenerators und die Güte der vorangegangenen Distanzmessung bzw. der vorangegangenen Abtastungen.

Erfindungsgemäss kann die zu wählende Abtastrate aber auch in analoger Weise mittels Aufrundungsfunktion $\lceil N \rceil$ gewählt werden, so dass sich folgende alternative Beziehung ergibt:

$$f_{n+1} = f_n \cdot \lceil N \rceil / N$$

wobei Ab- und Aufrundungsfunktionen auch in Form anderer Beziehungen ausgedrückt werden können, wie z.B. in der folgenden Weise

$$f_{n+1} = f_n \cdot \left( \lfloor N \rfloor + x \right) / N$$

wobei x eine positive oder negative ganze Zahl bezeichnet.

Eine andere erfindungsgemässe Möglichkeit besteht darin, die Abtastrate für das zweite Abtasten solange zu verändern, bis die erste Ableitung des Signals bzw. des Signalimpulses an den Abtastpunkten des Zielsignals Z maximal ist bzw. die Veränderung zu beenden, wenn die sich die erste Ableitung wieder verringert. Dieser Ansatz kann somit auf die ausschliessliche Betrachtung der Veränderungen des Zielsignals Z beschränkt werden und erlaubt somit auch die Verwendung eines elektronisch erzeugten Startsignals S, das sich somit in seiner Charakteristik und seiner Signalverarbeitung vollständig vom Zielsignal Z unterscheiden kann.

Dieser Ansatz der Abtastung mit wenigstens zwei unterschiedlichen Abtastraten kann erfindungsgemäss auch mit einer Filterung kombiniert werden, wie sie beispielsweise in der WO 2011/076907 beschrieben wird, so dass vor der Digitalisierung eine Filterung erfolgt.

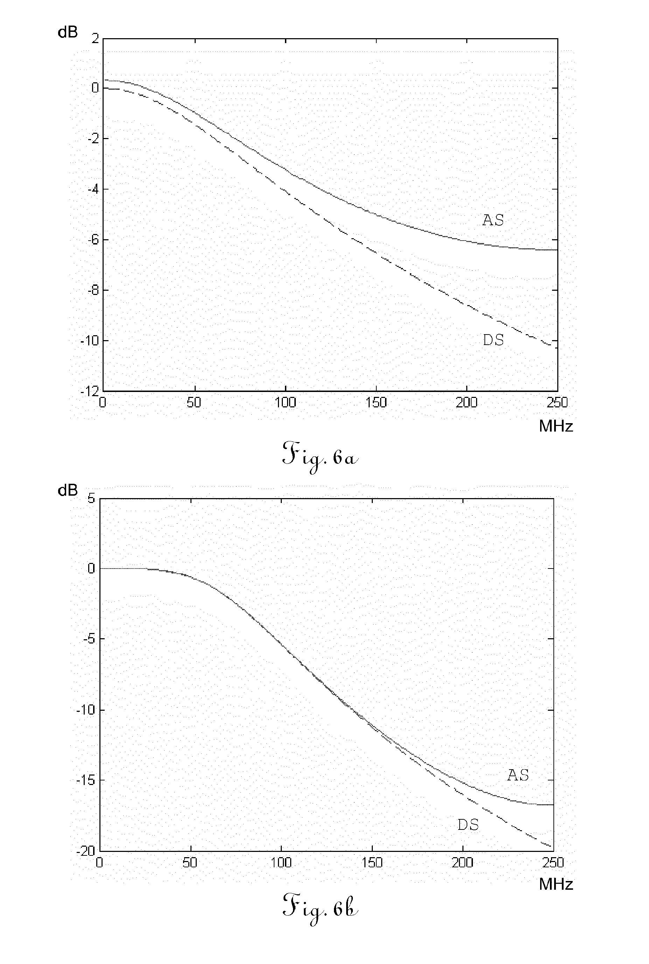

Die unterschiedlichen Spektren geeigneter Filter erster und zweiter Ordnung werden in Fig.6a-b dargestellt, wobei es sich um Tiefpass-Typen mit einer 3dB-Grenzfrequenz BW von 80MHz bei einer Abtastrate von 500 MHz handelt. Auf der horizontalen Achse ist die Frequenz in MHz und auf der vertikalen Achse die Abschwächung in dB angegeben, wobei die durchgezogene Linie das analoge Signal AS und die gestrichelte Linien das digitale Signal DS darstellen. Fig.6a zeigt ein Filter erster Ordnung, Fig.6b ein Filter zweiter Ordnung.

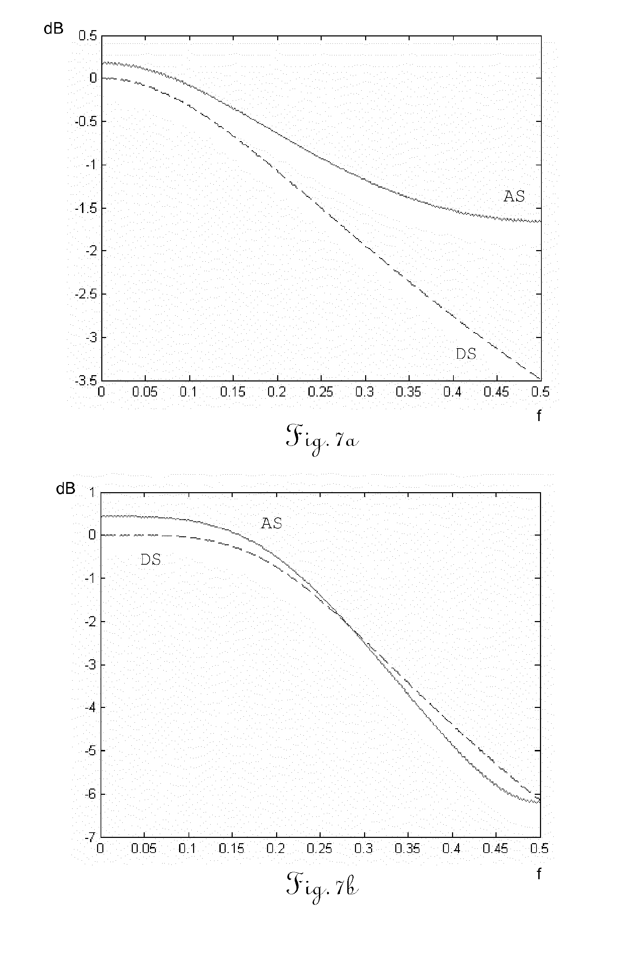

Die Spektren derselben Filter werden in den Fig.7a-b als Funktion der Abtastrate gezeigt, wobei auf der vertikalen Achse die Frequenz in Einheiten der Abtastrate angegeben.

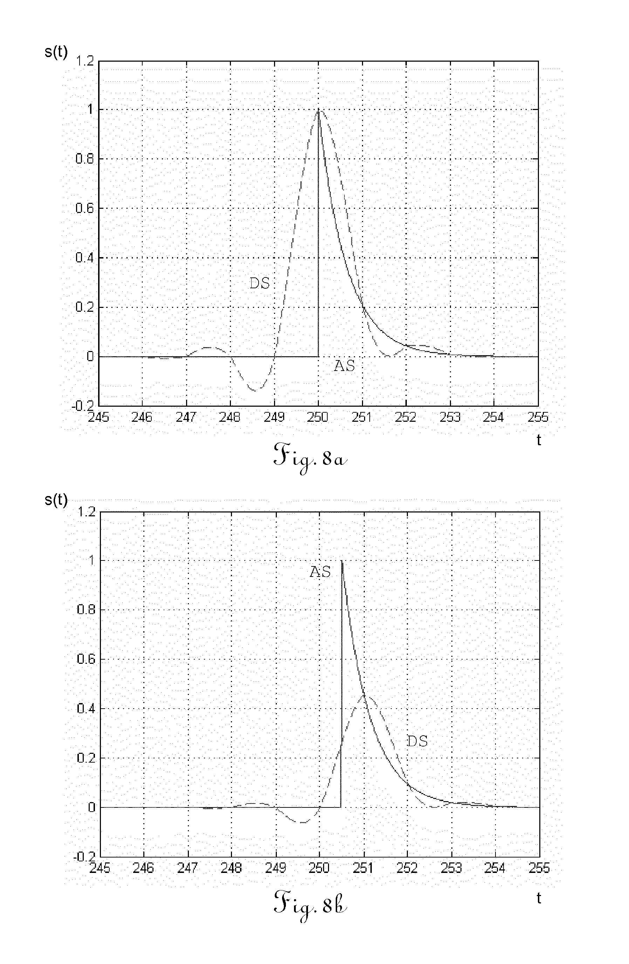

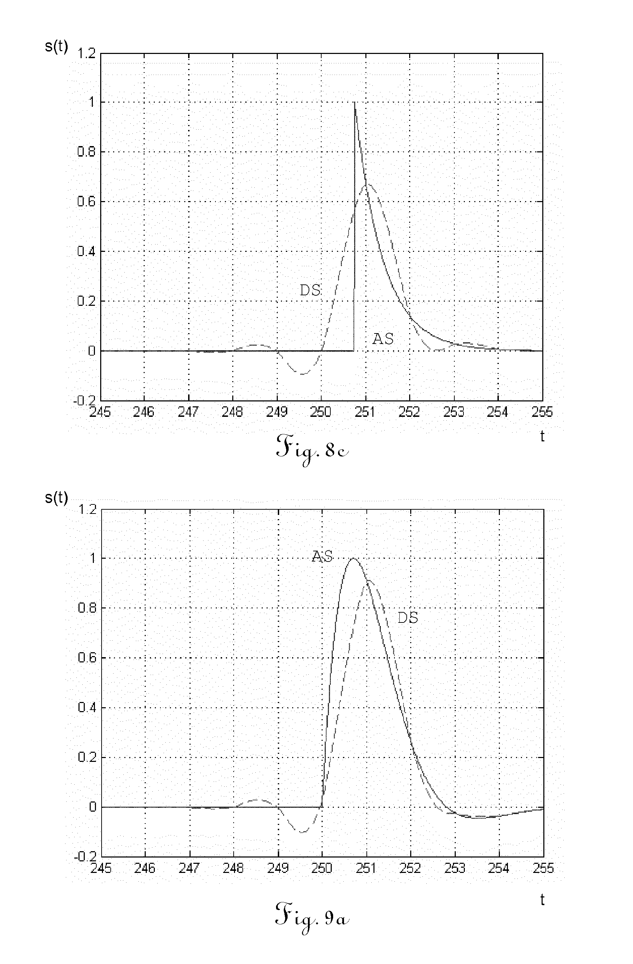

Die Fig.8a-c veranschaulichen die Unterschiede zwischen analogen Zeitsignal AS und aus diesem interpolierten digitalen Signal DS für ein Filter erster Ordnung und verschiedene beispielhafte Relativpositionen zwischen Zeitsignal und Abtastraster. Das durchgezogen gezeichnete analoge Zeitsignal AS wird in den Fig.8a-c an drei unterschiedlichen Positionen gegenüber dem Abtastraster dargestellt. In Fig.8a liegt das Maximum des Zeitsignals exakt auf dem mit der Zeiteinheit 250 markierten Abtastpunkt des Abtastrasters, wobei das aus dem abgetasteten Zeitsignal AS interpolierte digitale Signal DS an den Abtastpunkten identische Werte aufweist und in den Zwischenbereichen abweicht. Bei Fig. 8a liegt das Maximum des Zeitsignals AS direkt im Abtastraster, wobei auch das Maximum des digitalen Signals DS als Rekonstruktion an dieser Stelle zu liegen kommt. In den folgenden Fig.8b-c verschiebt sich die zeitliche Lage des Zeitsignals AS relativ zum Abtastraster nach rechts, so dass das Maximum des Zeitsignals AS nunmehr zwischen den Abtastpunkten mit den Zeiteinheiten 250 und 251 zu liegen kommt. Es ist zu erkennen, dass bei diesen verschiedenen Relativpositionen auch unterschiedliche Lagen von Maximum und Schwerpunkt des digitalen Signals DS folgen, so dass eine Abhängigkeit der Signalrekonstruktion von der Relativposition des Zeitsignals AS im Abtastraster entsteht, welche zu Distanzfehlern führt.

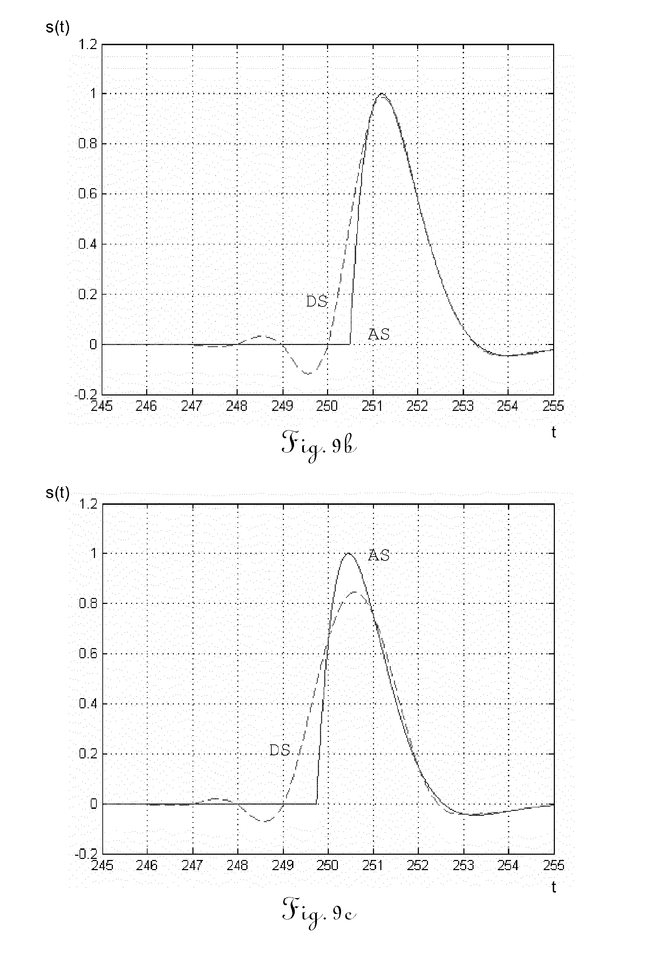

In den Fig.9a-c werden die entsprechenden Unterschiede zwischen analogen Zeitsignal und aus diesem interpolierten digitalen Signal für ein Filter zweiter Ordnung gezeigt, wobei aufgrund der Filterung die Abweichungen zwischen den Signalverläufen und damit auch die Distanzfehler geringer ausfallen.

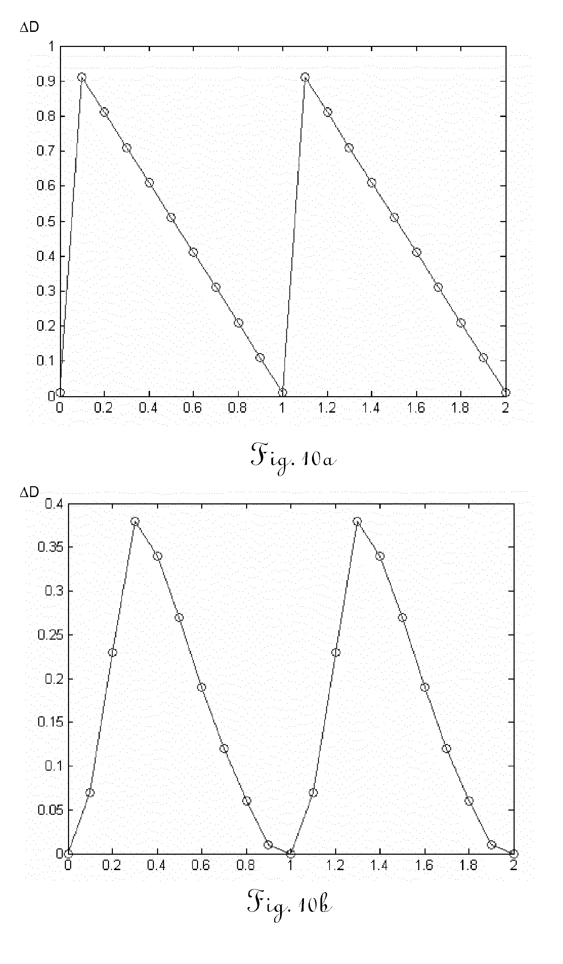

In den Fig.10a-b wird das Auftreten von Distanzfehlern $\Delta D$ bei der Abtastung eines Signals mit Filtern verschiedener Ordnung und Relativpositionen zwischen Signal und Abtastraster dargestellt. Gezeigt wird der durch die unterschiedlichen relativen Rasterlagen entstehende Fehler bei der Bestimmung der zeitlichen Lage des zu rekonstruierenden Signals relativ zu einem Referenzzeitpunkt, wobei aus der zeitlichen Lage über die Signallaufzeit die zu bestimmende Distanz folgt. Erkennbar wird der Distanzfehler der entsteht, wenn die Position über ein digital interpoliertes Signal bestimmt wird. Als Zeitposition wird die Position der Maximalwerte des analogen und des digital Interpolierten Signals angenommen. Auf der vertikalen Achse wird der Distanzfehler $\Delta D$ als Unterschied zwischen der Position der Maximalwerte gezeigt.

Die horizontale Achse bezeichnet die Verschiebung des Abtastrasters in Einheiten des Abstands der Abtastpunkte, d.h. die Verschiebung des Signals gegenüber dem Abtastraster. Beim in Fig.10a dargestellten Fall des Filters erster Ordnung ist erkennbar, dass der Fehler linear ansteigt und die wahre Distanz nur für den Fall der Übereinstimmung von Maximalwert und Abtastpunkt gegeben ist. In Fig.10b wird die gleiche Situation für ein Filter zweiter Ordnung gezeigt.

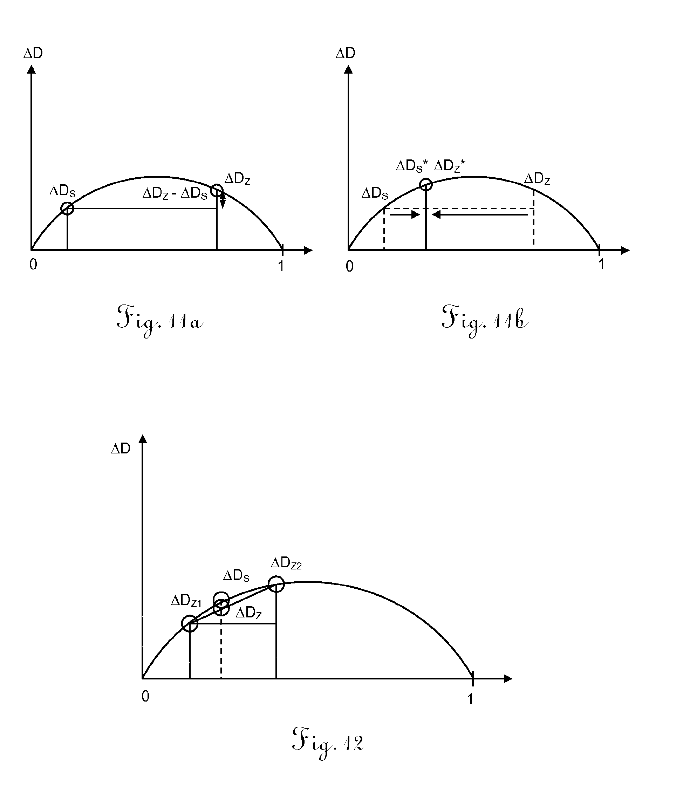

Bei der bisherigen Betrachtung ist der Fehler, der sich ggf. aus der zusätzlich erfolgenden Abtastung eines Startsignals oder eines anderen Referenzsignals ergibt, ausser Betracht. Dieser wird nachfolgend in den Fig.11a-b erläutert.

Fig.11a veranschaulicht den durch Aliasing-Effekte entstehenden Fehler $\Delta D_S$ für das Startsignal und den Fehler $\Delta D_Z$ für das Zielsignal. Gezeigt wird hierbei der in Abtastintervallen ausgedrückte Distanzfehler $\Delta D$ gegenüber der aufgrund der Periodizität im Intervall Null bis Eins angegebenen Verschiebung bzw. relativen Lage des Signalschwerpunkts zum Abtastraster. Wie auch im Stand der Technik bekannt ist, entstehen beim Rekonstruieren eines Signals Aliasing-Fehler. Diese sind um so grösser je weiter die Signalschwerpunkte gegenüber einem Abtastpunkt des Samplingrasters verschoben sind. Werden zwei Signale miteinander verglichen, entsteht abhängig von der Differenz ihrer Abtastzeitpunkte ein mehr oder weniger grosser Gesamtfehler $\Delta D_Z - \Delta D_S$ der zu bestimmenden Distanz.

Werden Startsignal und Zielsignal hingegen mit gleicher relativer Lage bzw. Phasenverschiebung gegenüber dem Abtastraster abgetastet, so verringert sich aufgrund der Differenzbildung der resultierende Fehler, wie dies in Fig. 11b für die durch die Anpassung der Abtastrate bewirkte Verschiebung der Fehler $\Delta D_S$ und $\Delta D_Z$ für Start- und Zielsignal zu $\Delta D_S^*$ und $\Delta D_Z^*$ gezeigt wird.

Erfindungsgemäss können die durch Aliasing auftretenden Fehler auch durch Mehrfachmessung der gleichen Distanz mit unterschiedlichen Abtastraten identifiziert bzw. verringert oder gänzlich eliminiert werden. Eine erste Möglichkeit wird in Fig.12 in Form einer linearen Interpolation des Zielsignals bzw. Stopp-Signals veranschaulicht. In diesem Beispiel wird das Zielsignal zweifach mit unterschiedlichen Raten abgetastet, wobei diese so gewählt werden, dass die resultierenden Verschiebungen auf beiden Seiten des ebenfalls abgetasteten Startsignals liegen. Bestimmt werden somit die beiden Distanzfehler $\Delta D_{Z1}$ und $\Delta D_{Z2}$ für die beiden Zielsignale und der Distanzfehler $\Delta D_S$ für das in seiner Relativlage zum Abtastraster unveränderte Startsignal. Aus den beiden Distanzfehlern $\Delta D_{Z1}$ und $\Delta D_{Z2}$ kann nachfolgend durch lineare Interpolation ein synthetischer Distanzfehler $\Delta D_Z$ für ein um den gleichen Betrag wie das Startsignal gegenüber dem Abtastraster verschobenes Zielsignal berechnet werden. Mit Hilfe dieses synthetischen Wertes kann dann der Fehler weitgehend oder vollständig eliminiert werden.

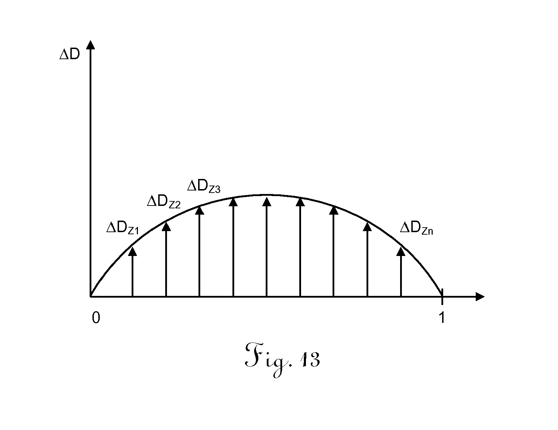

Die bei entsprechenden Verschiebungen gegenüber dem Abtastraster auftretenden systematischen Distanzfehler können auch für verschiedene Abtastraten, Messdistanzen und Konfigurationen, z.B. unterschiedliche Ziel- und Signalformen, bestimmt und erfindungsgemäss in einer Tabelle abgelegt werden. Dieser Fall ist in Fig.13 in Form einer Prinzipdarstellung einer erfindungsgemässen Erstellung einer Look-Up-Tabelle gezeigt, bei der für eine unveränderte Distanz und Messkonfiguration die verschiedenen Distanzfehler $\Delta D_{Z1}$, $\Delta D_{Z2}$, $\Delta D_{Z3}$ bis $\Delta D_{Zn}$ für n diskrete Abtastraten und daraus resultierend n äquidistante Verschiebungen gegenüber dem Abtastraster bestimmt werden.

**Patentansprüche**

1. Distanzmessverfahren, insbesondere nach dem Laufzeitmessverfahren, mit wenigstens einem

   ● Aussenden wenigstens eines Messsignals (MS), insbesondere eines Lichtsignals, auf ein Zielobjekt (2,13), wobei wenigstens ein Startsignal (S) erzeugt wird;
   ● Empfangen des vom Zielobjekt (2,13) zurückgestreuten Messsignals (MS) als Zielsignal (Z);
   ● erstes Abtasten des Zielsignals (Z) und Bestimmen der relativen Lage von Startsignal (S) und Zielsignal (Z);
   ● Ableiten einer Distanz zum Zielobjekt (2,13) aus der relativen Lage von Startsignal (S) und Zielsignal (Z), erfolgt;

   **gekennzeichnet durch**
   wenigstens ein zweites Abtasten des Zielsignals (Z), wobei das erste und zweite Abtasten unterschiedliche Abtastraten aufweisen.

2. Distanzmessverfahren nach Anspruch 1,
   die Abtastrate für das zweite Abtasten basierend auf einem Ergebnis des ersten Abtastens gewählt wird, insbesondere aufgrund einer auf dem ersten Abtasten basierenden Distanz zum Zielobjekt (2,13) bestimmt wird.

3. Distanzmessverfahren nach Anspruch 1 oder 2,
   **dadurch gekennzeichnet, dass**
   die Abtastrate für das zweite Abtasten basierend auf der Kenntnis einer Grobdistanz zum Zielobjekt (2,13) gewählt wird.

4. Distanzmessverfahren nach Anspruch 3,
   **dadurch gekennzeichnet, dass**
   die Abtastrate einer Tabelle entnommen wird, in der Grobdistanzen geeignete Abtastraten zugeordnet werden, insbesondere wobei die Zuordnung von Grobdistanzen zu Abtastraten auf der Basis vorangegangener Distanzmeßvorgänge erfolgt.

5. Distanzmessverfahren nach einem der vorangehenden Ansprüche,
   **dadurch gekennzeichnet, dass**
   ein synthetischer Distanzfehler für das Zielsignal (Z) bestimmt wird, insbesondere durch lineare Interpolation eines in seiner Lage verschobenen Zielsignals (Z).

**6.** Distanzmessverfahren nach einem der vorangehenden Ansprüche,
**dadurch gekennzeichnet, dass**
für das wenigstens zweite Abtasten eine Kopie des Messsignals (MS) durch Teilen des vom Zielobjekt (2,13) zurückgestreuten Messsignals (MS) erzeugt wird.

**7.** Distanzmessverfahren nach einem der vorangehenden Ansprüche,
**dadurch gekennzeichnet, dass**
für das wenigstens zweite Abtasten des Messsignals (MS) ein Wiederholen des Aussendens und Empfangens des Messsignals bei unveränderter Distanz oder mit bekannten Distanzunterschieden erfolgt.

**8.** Distanzmessverfahren nach einem der vorangehenden Ansprüche,
**dadurch gekennzeichnet, dass**
Startsignal (S) und Zielsignal (Z) beim ersten und/oder zweiten Abtasten gemeinsam abgetastet werden, insbesondere wobei das Startsignal (S) vor dem Aussenden als Kopie des Messsignals (MS) erzeugt wird, vorzugsweise durch Teilen des Messsignals (MS).

**9.** Distanzmessverfahren nach Anspruch 8,
**dadurch gekennzeichnet, dass**
die Abtastrate für das zweite Abtasten solange verändert wird, bis eine jeweilige Lage von Startsignal (S) und Zielsignal (Z) relativ zu einem der jeweiligen Abtastrate zugeordnetem Abtastraster gleich ist, so dass Start- und Zielsignal an gleichen Stellen des jeweiligen Signalverlaufs abgetastet werden.

**10.** Distanzmessverfahren nach Anspruch 8 oder 9,
**dadurch gekennzeichnet, dass**
die Abtastrate für das zweite Abtasten gemäss einer der folgenden Beziehungen gewählt wird

$$f_{n+1} = f_n \cdot \left(\lfloor N \rfloor + x\right)/N \quad \text{oder} \quad f_{n+1} = f_n \cdot \lfloor N \rfloor / N \quad \text{oder} \quad f_{n+1} = f_n \cdot \lceil N \rceil / N$$

wobei

$f_{n+1}$ die zu wählende Abtastrate für das zweite Abtasten,
$f_n$ die Abtastrate für das erste Abtasten,
$N$ die Zahl der Abtastintervalle zwischen dem Start- und dem Zielsignal,
$x$ eine positive oder negative ganze Zahl,
$\lfloor N \rfloor$ die Abrundungsfunktion und
$\lceil N \rceil$ die Aufrundungsfunktion für die Zahl der Abtastintervalle zwischen dem Start- und dem Zielsignal bezeichnen.

**11.** Distanzmessverfahren nach einem der Ansprüche 1 bis 7, **dadurch gekennzeichnet, dass**
die Abtastrate für das zweite Abtasten solange verändert wird, bis die erste Ableitung des Signals an den Abtastpunkten des Zielsignals (Z) maximal ist.

**12.** Distanzmessverfahren nach Anspruch 11,
**dadurch gekennzeichnet, dass**
das Startsignal elektronisch erzeugt wird.

**13.** Distanzmesser mit wenigstens

● einer Messsignalquelle (1) zum Aussenden wenigstens eines Messsignals (MS), insbesondere eines Lichtsignals, auf ein Zielobjekt (2,13), wobei wenigstens ein Startsignal (S) erzeugt wird, insbesondere durch Teilen des Messsignals (MS), wobei ein Teil des Messsignals (MS) über einen internen Referenzpfad geführt wird;
● einem Empfänger (3) zum Detektieren des vom Zielobjekt (2,13) zurückgestreuten Messsignals (MS) als Zielsignal (Z);
● einer Abtastschaltung zum Abtasten des Zielsignals (Z) zur Bestimmung der relativen Lage von Startsignal (S) und Zielsignal (Z);
● einer Steuer- und Auswertekomponente (9) zum Ableiten einer Distanz zum Zielobjekt (2,13) aus der relativen Lage von Startsignal (S) und Zielsignal (Z);

**dadurch gekennzeichnet dass**
die Abtastschaltung so ausgebildet ist, dass das Zielsignal (Z) mit wenigstens zwei unterschiedlichen Abtastraten abgetastet wird.

14. Distanzmesser nach Anspruch 13,
**dadurch gekennzeichnet, dass**
die Abtastschaltung einen Frequenzgenerator (10) aufweist, insbesondere einen Synthesizer, vorzugsweise einen Direct Digital Synthesizer oder einen Fractional-N Synthesizer.

15. Distanzmesser nach Anspruch 13 oder 14,
**dadurch gekennzeichnet, dass**
Empfänger (3) und Abtastschaltung so ausgebildet und angeordnet sind, dass das vom Zielobjekt (2,13) zurückgestreuten Messsignal (MS) geteilt und parallel in zwei Kanälen mit den unterschiedlichen Abtastraten abgetastet wird.

Fig. 4

Fig. 5

Fig. 6a

Fig. 6b

Fig. 7a

Fig. 7b

Fig. 8a

Fig. 8b

Fig. 8c

Fig. 9a

Fig. 9b

Fig. 9c

ΔD

Fig. 10a

ΔD

Fig. 10b

*Fig. 11a*

*Fig. 11b*

*Fig. 12*

Fig. 13

EP 2 680 029 A1

**Europäisches Patentamt**
**European Patent Office**
**Office européen des brevets**

## EUROPÄISCHER RECHERCHENBERICHT

Nummer der Anmeldung

EP 12 17 3911

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 0 875 772 A2 (ENDRESS HAUSER GMBH CO [DE] ENDRESS & HAUSER GMBH & CO KG [DE]) 4. November 1998 (1998-11-04) | 1-3,5-15 | INV. G01S7/486 H03M1/12 |
| Y | * Spalte 4, Zeilen 3-6; Abbildung 1 * * Spalte 6, Zeilen 11-15,24-29 * * Spalte 1, Zeile 50 - Spalte 2, Zeile 7 * * Spalte 4, Zeilen 3-13 * * Spalte 9, Zeilen 11-15 * ----- | 3,4 | |
| Y | WO 03/089950 A2 (TOOLZ LTD [US]) 30. Oktober 2003 (2003-10-30) * Seite 15, Zeile 12 - Seite 16, Zeile 8; Abbildung 6 * ----- | 3,4 | |
| A,D | EP 1 882 959 A1 (LEICA GEOSYSTEMS AG [CH]) 30. Januar 2008 (2008-01-30) * Absätze [0006], [0017], [0019] * ----- | 1-15 | |
| | | | **RECHERCHIERTE SACHGEBIETE (IPC)** H03M G01S |

Der vorliegende Recherchenbericht wurde für alle Patentansprüche erstellt

| Recherchenort | Abschlußdatum der Recherche | Prüfer |
|---|---|---|
| München | 30. November 2012 | Metz, Carsten |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
...............................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**                    EP 12 17 3911

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

30-11-2012

| Im Recherchenbericht angeführtes Patentdokument | | Datum der Veröffentlichung | Mitglied(er) der Patentfamilie | | Datum der Veröffentlichung |
|---|---|---|---|---|---|
| EP 0875772 | A2 | 04-11-1998 | CA | 2236500 A1 | 02-11-1998 |
| | | | EP | 0875772 A2 | 04-11-1998 |
| | | | JP | 3217749 B2 | 15-10-2001 |
| | | | JP | 10319111 A | 04-12-1998 |
| | | | US | 6122602 A | 19-09-2000 |
| WO 03089950 | A2 | 30-10-2003 | AU | 2003225029 A1 | 03-11-2003 |
| | | | AU | 2003228549 A1 | 03-11-2003 |
| | | | AU | 2003228550 A1 | 03-11-2003 |
| | | | EP | 1499851 A2 | 26-01-2005 |
| | | | EP | 1499852 A2 | 26-01-2005 |
| | | | EP | 1502224 A2 | 02-02-2005 |
| | | | US | 2004070745 A1 | 15-04-2004 |
| | | | US | 2004070746 A1 | 15-04-2004 |
| | | | US | 2004075823 A1 | 22-04-2004 |
| | | | WO | 03089948 A2 | 30-10-2003 |
| | | | WO | 03089949 A2 | 30-10-2003 |
| | | | WO | 03089950 A2 | 30-10-2003 |
| EP 1882959 | A1 | 30-01-2008 | AU | 2007276473 A1 | 24-01-2008 |
| | | | CA | 2657677 A1 | 24-01-2008 |
| | | | CN | 101490579 A | 22-07-2009 |
| | | | EP | 1882959 A1 | 30-01-2008 |
| | | | EP | 2041604 A1 | 01-04-2009 |
| | | | JP | 2009544023 A | 10-12-2009 |
| | | | US | 2009262330 A1 | 22-10-2009 |
| | | | WO | 2008009387 A1 | 24-01-2008 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2011076907 A